# EUROPEAN PATENT SPECIFICATION

(11) **EP 4 366 952 B1**
(45) Date of publication and mention of the grant of the patent: **11.03.2026**
(21) Application number: 21748745.3
(22) Date of filing: 06.07.2021
(51) Int. Cl.: B41J 2/045, B41J 2/175, G11C 7/22, G11C 5/14

(54) **INTEGRATED CIRCUITS INCLUDING FIRST AND SECOND POWER SUPPLY NODES FOR WRITING AND READING MEMORY CELLS**
INTEGRIERTE SCHALTUNGEN MIT ERSTEN UND ZWEITEN STROMVERSORGUNGSKNOTEN ZUM SCHREIBEN UND LESEN VON SPEICHERZELLEN
CIRCUITS INTÉGRÉS COMPRENANT DES PREMIER ET SECOND NOEUDS D'ALIMENTATION ÉLECTRIQUE PERMETTANT D'ÉCRIRE DANS DES CELLULES DE MÉMOIRE ET DE LIRE À PARTIR DE CES DERNIÈRES

(43) Date of publication of application: 15.05.2024
(73) Proprietor: Hewlett-Packard Development Company, L.P., Spring TX 77389 (US)
(72) Inventor: GARDNER, James Michael, Corvallis, Oregon 97330-4241 (US); LINN, Scott A., Corvallis, Oregon 97330-4241 (US)
(74) Representative: Hoffmann Eitle
(86) International application number: PCT/US2021/040581
(87) International publication number: WO 2023/282891

(56) References cited:
- WO-A1-2020/162914
- WO-A1-2020/162969

## Description

### Background

An inkjet printing system, as one example of a fluid ejection system, may include an integrated circuit, such as a fluidic die, an ink supply which supplies liquid ink to the fluidic die, and an electronic controller which controls the fluidic die. The fluidic die, as one example of a fluid ejection device, ejects drops of ink through a plurality of nozzles or orifices and toward a print medium, such as a sheet of paper, so as to print onto the print medium. In some examples, the orifices are arranged in a single column or array or multiple columns or arrays such that properly sequenced ejection of ink from the orifices causes characters or other images to be printed upon the print medium as the fluidic die and/or the print medium are moved relative to each other.

WO 2020/162914 A1 discloses an example integrated circuit with a memory voltage regulator.

### Brief Description of the Drawings

FIG. 1A is a block diagram illustrating one example of an integrated circuit for association with a plurality of fluid actuation devices.
FIG. 1B is a block diagram illustrating one example of a fluidic die.
FIG. 2 is a block diagram illustrating one example of a voltage regulator circuit for generating a memory-write voltage and the memory-read voltage.
FIGS. 3A-3D are flow diagrams illustrating one example of a method for accessing a plurality of memory cells of an integrated circuit.
FIGS. 4A and 4B illustrate one example of a fluidic die.
FIG. 5 is a block diagram illustrating one example of a fluid ejection system.
FIG. 6A is a diagram illustrating one example of a print cartridge including an integrated circuit.
FIG. 6B is a diagram illustrating one example of an integrated circuitry package for attachment to the print cartridge of FIG. 6A.

### Detailed Description

Each of the figures may be considered as representing multiple embodiments, whereby the figures can be used for reference purposes to support the multiple embodiments disclosed in the description. The skilled person understands that all individual, or combinations of, features illustrated or described with reference to any one of the figures may be combined with individual, or combinations of, features illustrated or described with reference to any of the other figures.

In the following detailed description, reference is made to the accompanying drawings which form a part hereof, and in which is shown by way of illustration specific examples in which the disclosure may be practiced. It is to be understood that other examples may be utilized and structural or logical changes may be made without departing from the scope of the present disclosure. The following detailed description, therefore, is not to be taken in a limiting sense, and the scope of the present disclosure is defined by the appended claims. It is to be understood that features of the various examples described herein may be combined, in part or whole, with each other, unless specifically noted otherwise.

Print systems are typically provided with host printers and replaceable inkjet cartridges that are replaceable with respect to compatible receiving stations of the host printer. Inkjet cartridges may be provided with printheads. Inkjet cartridges may be provided with ink reservoirs to supply ink to the printheads. Printheads typically include or consist of integrated circuits, such as fluidic dies (also referred to as fluid ejection dies), that are provided with fluid channels and fluid ejection actuators to eject the ink. The fluid ejection dies are provided with memory cells. Logic (switching) circuitry is provided in the die to enable individual and/or groups of fluid actuators and memory cells. The combination of circuitry on the die may be referred to as integrated circuitry. Signal contacts are provided on the cartridge to connect to corresponding contacts of the host printer to transmit signals between the integrated circuitry and a host printer controller.

Most embodiments of this disclosure will refer to fluid ejection dies and their on board memories. Other embodiments of this disclosure are separate integrated circuit packages, external to the fluid ejection die and excluding fluid actuators. The separate integrated circuit packages comprise replacement memories, to replace the on-die memory, in which memory read and write functions are at least partially configured in the same way as the on-die integrated circuitry. These off-die integrated circuit packages may be used to refurbish previously used exhausted inkjet cartridges, for example, for refilling and/or resetting the ink level. Other off-die integrated circuit packages could be provided for new printhead cartridges instead of on-die memory functions, whereby memory and ink ejection functions may be provided in separate packages. For example, the memory may be provided on a flat package such as a flexible circuit while the ink ejection functions are provided in the printhead. All the different embodiments of print cartridge integrated circuitry components may be configured to process input signals from a connected host printer to power, read, and write memory cells.

A fluidic die or integrated circuitry package may include on-die non-volatile memory (NVM) bits (e.g., one-time programmable (OTP) NVM) to store information accumulated throughout the life of the fluidic die, such as manufacturing tracking data and in-product usage statistics (e.g., total pages printed, etc.). The OTP and/or NVM cells may include programmable read-only memory (PROM) cells, erasable programmable read-only memory (EPROM) cells, fuses, anti-fuses, reference resistors, or other suitable memory cells. The NVM circuitry may use two unique voltages for read and write operations. Typically, both voltages are generated from a single high voltage supply using a voltage regulator. This high voltage supply used for NVM circuits may also be used to fire fluid actuation devices and for warming circuits. Thus, to read the NVM bits, the supply node (i.e., bus) used to connect the high voltage supply to the components of the fluidic die cannot be disabled (e.g., due to damage or other causes). Unfortunately, the high voltage supply node may be prone to electrical damage (e.g., short circuit) due to failed fluid actuation devices and/or electrical overstress (EOS) events. If a failure of the high voltage supply node occurs, NVM data stored in the failed fluidic die may be inaccessible to failure analysis technicians or return centers. In some cases, a failed high voltage supply node may even damage NVM circuits or corrupt data stored in NVM cells. For commercial/industrial print businesses, the ability to efficiently diagnose fluidic dies that have been returned by customers is desirable. Proper diagnosis may include the ability to robustly read the NVM data.

Accordingly, disclosed herein are print cartridge integrated circuit components (e.g., fluidic dies) including memory cells (e.g., non-volatile memory cells, such as one-time-programmable memory cells). A first power supply, such as a high voltage power supply, is used to power the writing of data to the memory cells. For example, a power supply between approximately 10V and 35V may be used to supply power for writing the data. In one example, the first power supply is configured to supply 32V. A second power supply, such as a low voltage power supply, is used to power the reading of data from the memory cells. For example, a power supply between approximately 3V and 7V may be used to supply power for reading the data. In one example, the second power supply is configured to supply 5.6V.

In one example, a dual output voltage regulator circuit is used to generate a memory-write voltage (e.g., 11 V) from the first power supply and a memory-read voltage (e.g., 5 V) from the second power supply. The voltage regulator can generate the memory-read voltage without the presence of the first power supply. In one example, even if the fluidic die fails due to damage to the high voltage supply node, the memory cells may still be read. In a further example, the memory cells may be read independent of the high power supply, for example without an active high power supply, such as at initiating the integrated circuit for reading the memory cells prior to enabling the high power supply. In addition, the risk of corruption of the data stored in the memory cells due to failure of the high voltage supply node of the fluidic die is reduced.

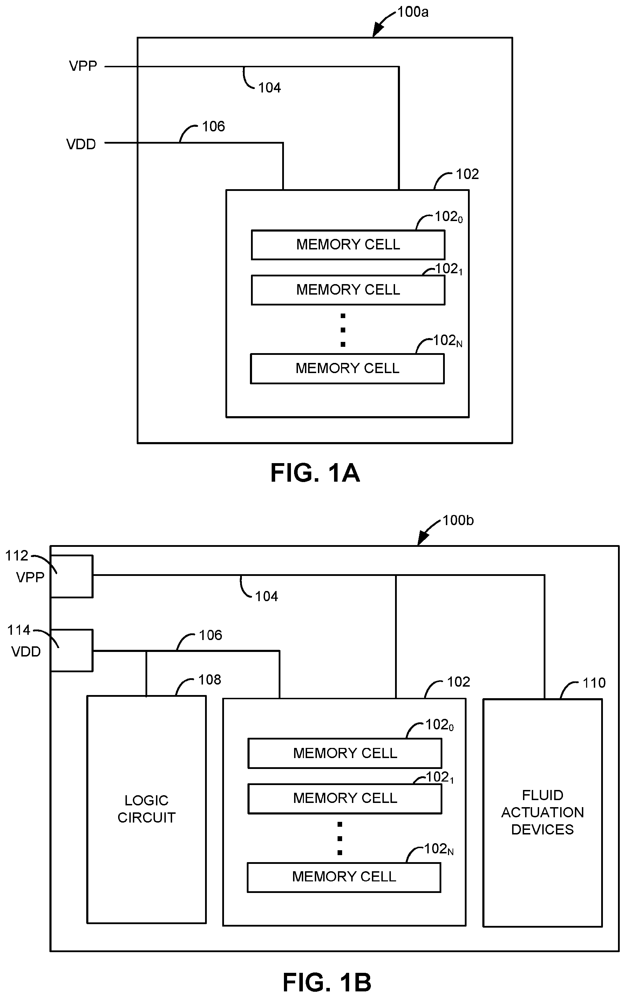

FIG. 1A is a block diagram illustrating one example of an integrated circuit 100a for association with a plurality of fluid actuation devices. In this example, integrated circuit 100a may be separate from an integrated circuit including fluid actuation devices, but used in association with the integrated circuit including the fluid actuation devices. Integrated circuit 100a includes a plurality of memory cells 102, a first power supply node 104 (e.g., a high voltage power supply node), and a second power supply node 106 (e.g., a low voltage power supply node). The plurality of memory cells 102 includes memory cells 102₀ to 102_{N}, where "N" is any suitable number of memory cells. The first power supply node 104 is to supply power to the plurality of memory cells 102 to write data to the plurality of memory cells 102. The second power supply node 106 is to supply power to the plurality of memory cells 102 to read data from the plurality of memory cells 102. Integrated circuit 100a may include logic (not shown) for reading and/or writing to the plurality of memory cells 102. Since the first power supply node 104 is not used to supply power to the plurality of memory cells 102 for read operations, the plurality of memory cells 102 are readable with the first power supply node 104 disabled.

The first power supply node 104 is to supply a first voltage and a first maximum current to the integrated circuit 100a. The second power supply node 106 is to supply a second voltage and a second maximum current to the integrated circuit 100a. The first voltage is greater than the second voltage, and the first maximum current is greater than the second maximum current. The first power supply node 104 may be electrically coupled to a high voltage supply (e.g., VPP) to receive the first voltage and first maximum current. The second power supply node 106 may be electrically coupled to a low voltage supply (e.g., VDD) to receive the second voltage and the second maximum current. The first voltage supplied by the first power supply node 104 may be at least three times the second voltage supplied by the second power supply node 106 (i.e., the first voltage supplied by the first power supply node 104 may be three times the second voltage or more than three times the second voltage supplied by the second power supply node 106). In one example, the first voltage supplied by the first power supply node 104 is greater than about 15 V (e.g., within a range between about 15 V and about 50 V, such as about 32 V), and the second voltage supplied by the second power supply node 106 is less than about 15 V (e.g., 5.6 V). In one example, the first maximum current may be greater than about 1 A (e.g., within a range between about 1 A and about 10 A), and the second maximum current may be less than about 1 A (e.g., within a range between about 50 mA and about 500 mA).

FIG. 1B is a block diagram illustrating another example of an integrated circuit 100b (e.g., a fluidic die). Fluidic die 100b includes memory cells 102, first power supply node 104, and second power supply node 106 as previously described and illustrated with reference to FIG. 1A. In addition, fluidic die 100b includes a logic circuit 108, a plurality of fluid actuation devices 110, a first contact pad 112, and a second contact pad 114. The first power supply node 104 is to supply power to the plurality of fluid actuation devices 110. The second power supply node 106 is to supply power to the logic circuit 108.

The first contact pad 112 is electrically coupled to the first power supply node 104. While one first contact pad 112 is illustrated in FIG. 1B, in other examples, fluidic die 100b may include more than one first contact pad electrically coupled to the first power supply node 104. The second contact pad 114 is electrically coupled to the second power supply node 106. While one second contact pad 114 is illustrated in FIG. 1B, in other examples, fluidic die 100b may include more than one second contact pad electrically coupled to the second power supply node 106.

The logic circuit 108 is to receive power from the second power supply node 106. Logic circuit 108 may control the operation of fluidic die 100b including reading and writing data to the plurality of memory cells 102 and controlling firing of the plurality of fluid actuation devices 110.

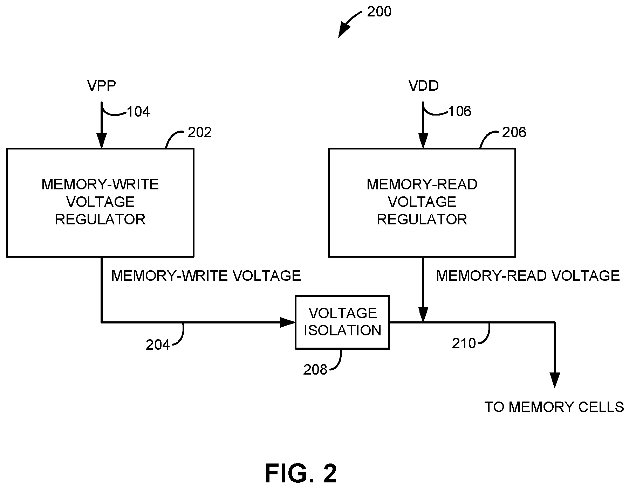

FIG. 2 is a block diagram illustrating one example of a voltage regulator circuit 200 for generating a memory-write voltage and the memory-read voltage. In one example, voltage regulator circuit 200 may be included in integrated circuit 100a of FIG. 1A or 100b of FIG. 1B. Voltage regulator circuit 200 includes a first voltage regulator 202 (e.g., a memory-write voltage regulator), a second voltage regulator 206 (e.g., a memory-read voltage regulator), a voltage isolation component 208, and a memory cell power node 210. An input of the first voltage regulator 202 is electrically coupled to the first power supply node 104 to receive the first voltage (e.g., VPP). An output of first voltage regulator 202 is electrically coupled to an input of voltage isolation component 208 through a signal path 204. An input of the second voltage regulator 206 is electrically coupled to the second power supply node 106 to receive the second voltage (e.g., VDD). An output of the second voltage regulator 206 and an output of the voltage isolation component 208 are electrically coupled to the memory cell power node 210. The memory cell power node 210 is electrically coupled to the plurality of memory cells 102₀ to 102_{N} (FIGS. 1A-1B).

The first voltage regulator 202 is to generate a memory-write voltage on the signal path 204 based on the first voltage to write data to the plurality of memory cells. The memory-write voltage may be less than the first voltage. Voltage isolation component 208 passes the memory-write voltage on signal path 204 to the memory cell power node 210. The voltage isolation component 208 electrically isolates the first voltage regulator 202 from the second voltage regulator 206 and from the memory cell power node 210. The voltage isolation component may include a high voltage diode, a high voltage isolation switch, or other suitable high voltage isolation circuit or device.

The second voltage regulator 206 is to generate a memory-read voltage on the memory cell power node 210 based on the second voltage to read data from the plurality of memory cells. The memory-read voltage may be less than or equal to the second voltage. In one example, the first voltage regulator 202 and the second voltage regulator 206 are disabled until a write or read request is received (e.g., from logic circuit 108). In response to a write request, the first voltage regulator 202 is enabled to provide the memory-write voltage on memory cell power node 210, data is written to the selected memory cells, and the first voltage regulator 202 is then disabled. In response to a read request, the second voltage regulator 206 is enabled to provide the memory-read voltage on memory cell power node 210, data is read from the selected memory cells, and the second voltage regulator 206 is then disabled.

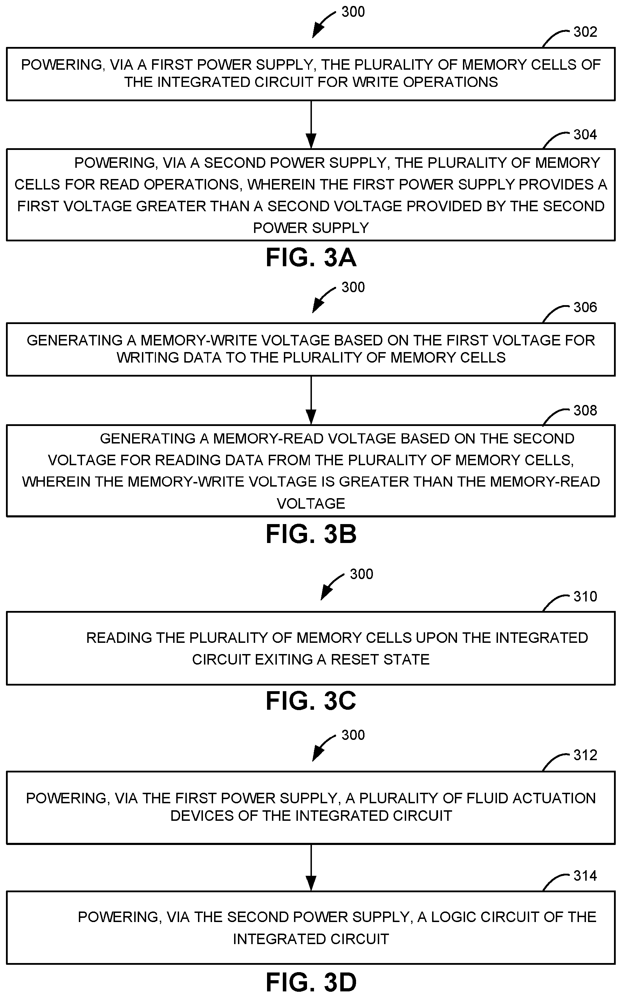

FIGS. 3A-3D are flow diagrams illustrating one example of a method 300 for accessing a plurality of memory cells (e.g., 102) of an integrated circuit (e.g., 100a or 100b). As illustrated in FIG. 3A at 302, method 300 includes powering, via a first power supply (e.g., VPP), the plurality of memory cells of the integrated circuit for write operations. At 304, method 300 includes powering, via a second power supply (e.g., VDD), the plurality of memory cells for read operations, wherein the first power supply provides a first voltage greater than a second voltage provided by the second power supply.

As illustrated in FIG. 3B at 306, method 300 may further include generating a memory-write voltage based on the first voltage for writing data to the plurality of memory cells (e.g., via memory-write voltage regulator 202). At 308, method 300 may further include generating a memory-read voltage based on the second voltage for reading data from the plurality of memory cells (e.g., via memory-read voltage regulator 206), wherein the memory-write voltage is greater than the memory-read voltage.

As illustrated in FIG. 3C at 310, method 300 may further include reading the plurality of memory cells upon the integrated circuit exiting a reset state. Upon exiting of a reset state (e.g., for die initialization), the first power supply may be disabled (or blocked) but the second power supply may be enabled, thus enabling reading of the plurality of memory cells but not writing to the plurality of memory cells.

As illustrated in FIG. 3D at 312, method 300 may further include powering, via the first power supply, a plurality of fluid actuation devices (e.g., 110) of the integrated circuit. At 314, method 300 may further include powering, via the second power supply, a logic circuit (e.g., 108) of the integrated circuit.

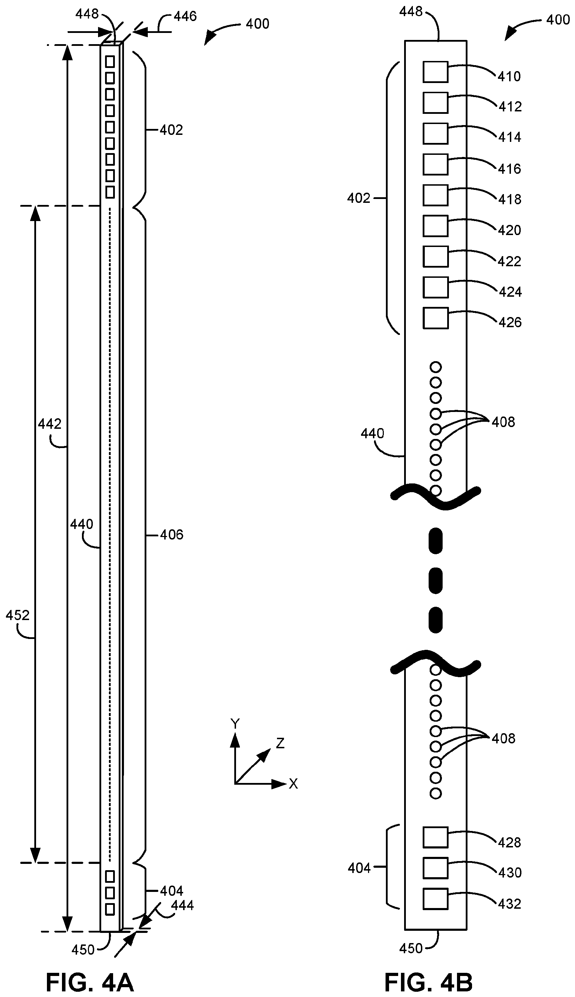

FIG. 4A illustrates one example of a fluidic die 400 and FIG. 4B illustrates an enlarged view of the ends of fluidic die 400. In one example, fluidic die 400 includes integrated circuit 100a of FIG. 1A, integrated circuit 100b of FIG. 1B, and/or regulator circuit 200 of FIG. 2. Fluidic die 400 includes a first column 402 of contact pads, a second column 404 of contact pads, and a column 406 of fluid actuation devices 408.

The second column 404 of contact pads is aligned with the first column 402 of contact pads and at a distance (i.e., along the Y axis) from the first column 402 of contact pads. The column 406 of fluid actuation devices 408 is disposed longitudinally to the first column 402 of contact pads and the second column 404 of contact pads. The column 406 of fluid actuation devices 408 is also arranged between the first column 402 of contact pads and the second column 404 of contact pads. In one example, fluid actuation devices 408 are nozzles or fluidic pumps to eject fluid drops.

In one example, the first column 402 of contact pads includes nine contact pads. The first column 402 of contact pads may include the following contact pads in order: a data contact pad 410, a clock contact pad 412, a mode contact pad 414, a multipurpose input/output contact (e.g., sense) pad 416, a logic power ground return contact pad 418, a logic reset contact pad 420, a fire contact pad 422, a first high voltage power supply contact pad 424, and a first high voltage power ground return contact pad 426. In one example, the first high voltage power supply contact pad 424 provides the contact pad 112 electrically coupled to the first power supply node 104 as previously described and illustrated with reference to FIG. 1B. Therefore, the first column 402 of contact pads includes the data contact pad 410 at the top of the first column 402, the first high voltage power ground return contact pad 426 at the bottom of the first column 402, and the first high voltage power supply contact pad 424 directly above the first high voltage power ground return contact pad 426. While contact pads 410, 412, 414, 416, 418, 420, 422, 424, and 426 are illustrated in a particular order, in other examples the contact pads may be arranged in a different order. In other examples, there may be an additional two contact pads (not shown) above the data contact pad 410 that are not connected to any fluidic die 400 circuitry. The additional two contact pads may be used for wirebond jumpering between multiple fluidic dies during manufacturing of a multi-die printhead, such as a color printhead.

In one example, the second column 404 of contact pads includes three contact pads. The second column 404 of contact pads may include the following contact pads in order: a second high voltage power supply contact pad 428, a second high voltage power ground return contact pad 430, and a logic power supply contact pad 432. In one example, the logic power supply contact pad 432 provides the contact pad 114 electrically coupled to the second power supply node 106 as previously described and illustrated with reference to FIG. 1B. Therefore, the second column 404 of contact pads includes the second high voltage power supply contact pad 428 at the top of the second column 404, the second high voltage power ground return contact pad 430 directly below the second high voltage power supply contact pad 428, and the logic power supply contact pad 432 at the bottom of the second column 404. While contact pads 428, 430, and 432 are illustrated in a particular order, in other examples the contact pads may be arranged in a different order.

Data contact pad 410 may be used to input serial data to die 400 for selecting fluid actuation devices, memory bits, thermal sensors, configuration modes (e.g., via a configuration register), etc. Data contact pad 410 may also be used to output serial data from die 400 for reading memory bits, configuration modes, status information (e.g., via a status register), etc. Clock contact pad 412 may be used to input a clock signal to die 400 to shift serial data on data contact pad 410 into the die or to shift serial data out of the die to data contact pad 410. Mode contact pad 414 may be used as a logic input to control access to enable/disable configuration modes (i.e., functional modes) of die 400. Multipurpose input/output contact pad 416 may be used for analog sensing and/or digital test modes of die 400. Logic power ground return contact pad 418 provides a ground return path for logic power (e.g., about 0 V) supplied to die 400. In one example, logic power ground return contact pad 418 is electrically coupled to the semiconductor (e.g., silicon) substrate 440 of die 400.

Logic reset contact pad 420 may be used as a logic reset input to control the operating state of die 400. Fire contact pad 422 may be used as a logic input to latch loaded data from data contact pad 410 and to enable fluid actuation devices or memory elements of die 400. Logic power supply contact pad 432 may be used to supply logic power (e.g., between about 1.8 V and about 15 V, such as about 5.6 V) to die 400.

First high voltage power supply contact pad 424 and second high voltage power supply contact pad 428 may be used to supply high voltage (e.g., about 32 V) to die 400. First high voltage power ground return contact pad 426 and second high voltage power ground return contact pad 430 may be used to provide a power ground return (e.g., about 0 V) for the high voltage power supply. The high voltage power ground return contact pads 426 and 430 are not directly electrically connected to the semiconductor substrate 440 of die 400. The specific contact pad order with the high voltage power supply contact pads 424 and 428 and the high voltage power ground return contact pads 426 and 430 as the innermost contact pads may improve power delivery to die 400. Having the high voltage power ground return contact pads 426 and 430 at the bottom of the first column 402 and in the middle of the second column 404, respectively, may improve reliability for manufacturing and may improve ink shorts protection.

Die 400 includes an elongate substrate 440 having a length 442 (along the Y axis), a thickness 444 (along the Z axis), and a width 446 (along the X axis). In one example, the length 442 is at least twenty times the width 446. The width 446 may be 1 mm or less and the thickness 444 may be less than 500 microns. The fluid actuation devices 408 (e.g., fluid actuation logic) and contact pads 410-432 are provided on the elongate substrate 440 and are arranged along the length 442 of the elongate substrate. Fluid actuation devices 408 have a swath length 452 less than the length 442 of the elongate substrate 440. In one example, the swath length 452 is at least 1.2 cm. The contact pads 410-432 may be electrically coupled to the fluid actuation logic. The first column 402 of contact pads may be arranged near a first longitudinal end 448 of the elongate substrate 440. The second column 404 of contact pads may be arranged near a second longitudinal end 450 of the elongate substrate 440 opposite to the first longitudinal end 448.

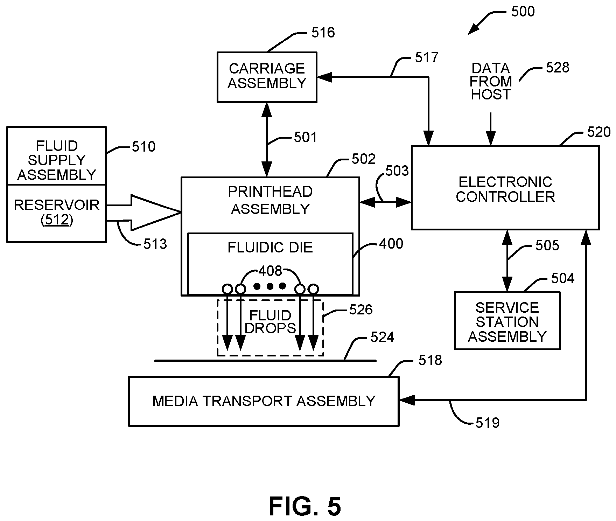

FIG. 5 is a block diagram illustrating one example of a fluid ejection system 500. Fluid ejection system 500 includes a fluid ejection assembly, such as printhead assembly 502, and a fluid supply assembly 510, such as an ink supply assembly. In the illustrated example, fluid ejection system 500 also includes a service station assembly 504, a carriage assembly 516, a print media transport assembly 518, and an electronic controller 520. While the following description provides examples of systems and assemblies for fluid handling with regard to ink, the disclosed systems and assemblies are also applicable to the handling of fluids other than ink.

Printhead assembly 502 includes a single printhead or fluidic die 400 or multiple printheads or fluidic dies 400 including fluid actuation devices (e.g., ejecting actuators or non-ejecting actuators, such as micro-fluidic pumps to move fluid in microfluidic channels). The fluidic die 400 may eject drops of ink or fluid through a plurality of orifices or nozzles 408. In one example, the drops are directed toward a medium, such as print media 524, so as to print onto print media 524. In one example, print media 524 includes any type of suitable sheet material, such as paper, card stock, transparencies, Mylar, fabric, and the like. In another example, print media 524 includes media for three-dimensional (3D) printing, such as a powder bed, or media for bioprinting, drug discovery testing, and/or other life-science applications, such as a reservoir, a container, or receptacles. In one example, nozzles 408 are arranged in a single column or array or multiple columns or arrays such that properly sequenced ejection of fluid from nozzles 408 causes characters, symbols, and/or other graphics or images to be printed upon print media 524 as printhead assembly 502 and print media 524 are moved relative to each other.

Fluid supply assembly 510 supplies fluid (e.g., ink) to printhead assembly 502 and includes a reservoir 512 for storing fluid. As such, in one example, fluid flows from reservoir 512 to printhead assembly 502. In one example, printhead assembly 502 and fluid supply assembly 510 are housed together in an inkjet or fluid-jet print cartridge or pen. In another example, fluid supply assembly 510 is separate from printhead assembly 502 and supplies fluid to printhead assembly 502 through an interface connection 513, such as a supply tube and/or valve.

Carriage assembly 516 positions printhead assembly 502 relative to print media transport assembly 518, and print media transport assembly 518 positions print media 524 relative to printhead assembly 502. Thus, a print zone 526 is defined adjacent to nozzles 408 in an area between printhead assembly 502 and print media 524. In one example, printhead assembly 502 is a scanning type printhead assembly such that carriage assembly 516 moves printhead assembly 502 relative to print media transport assembly 518. In another example, printhead assembly 502 is a non-scanning type printhead assembly such that carriage assembly 516 fixes printhead assembly 502 at a prescribed position relative to print media transport assembly 518.

Service station assembly 504 provides for spitting, wiping, capping, and/or priming of printhead assembly 502 to maintain the functionality of printhead assembly 502 and, more specifically, nozzles 408. For example, service station assembly 504 may include a rubber blade or wiper which is periodically passed over printhead assembly 502 to wipe and clean nozzles 408 of excess fluid. In addition, service station assembly 504 may include a cap that covers printhead assembly 502 to protect nozzles 408 from drying out during periods of non-use. In addition, service station assembly 504 may include a spittoon into which printhead assembly 502 ejects fluid during spits to ensure that reservoir 512 maintains an appropriate level of pressure and fluidity, and to ensure that nozzles 408 do not clog or weep. Functions of service station assembly 504 may include relative motion between service station assembly 504 and printhead assembly 502.

Electronic controller 520 communicates with printhead assembly 502 through a communication path 503, service station assembly 504 through a communication path 505, carriage assembly 516 through a communication path 517, and print media transport assembly 518 through a communication path 519. In one example, when printhead assembly 502 is mounted in carriage assembly 516, electronic controller 520 and printhead assembly 502 may communicate via carriage assembly 516 through a communication path 501. Electronic controller 520 may also communicate with fluid supply assembly 510 such that, in one implementation, a new (or used) fluid supply may be detected.

Electronic controller 520 receives data 528 from a host system, such as a computer, and may include memory for temporarily storing data 528. Data 528 may be sent to fluid ejection system 500 along an electronic, infrared, optical or other information transfer path. Data 528 represent, for example, a document and/or file to be printed. As such, data 528 form a print job for fluid ejection system 500 and includes a single print job command and/or command parameter or multiple print job commands and/or command parameters.

In one example, electronic controller 520 provides control of printhead assembly 502 including timing control for ejection of fluid drops from nozzles 408. As such, electronic controller 520 defines a pattern of ejected fluid drops which form characters, symbols, and/or other graphics or images on print media 524. Timing control and, therefore, the pattern of ejected fluid drops, is determined by the print job commands and/or command parameters. In one example, logic and drive circuitry forming a portion of electronic controller 520 is located on printhead assembly 502. In another example, logic and drive circuitry forming a portion of electronic controller 520 is located off printhead assembly 502.

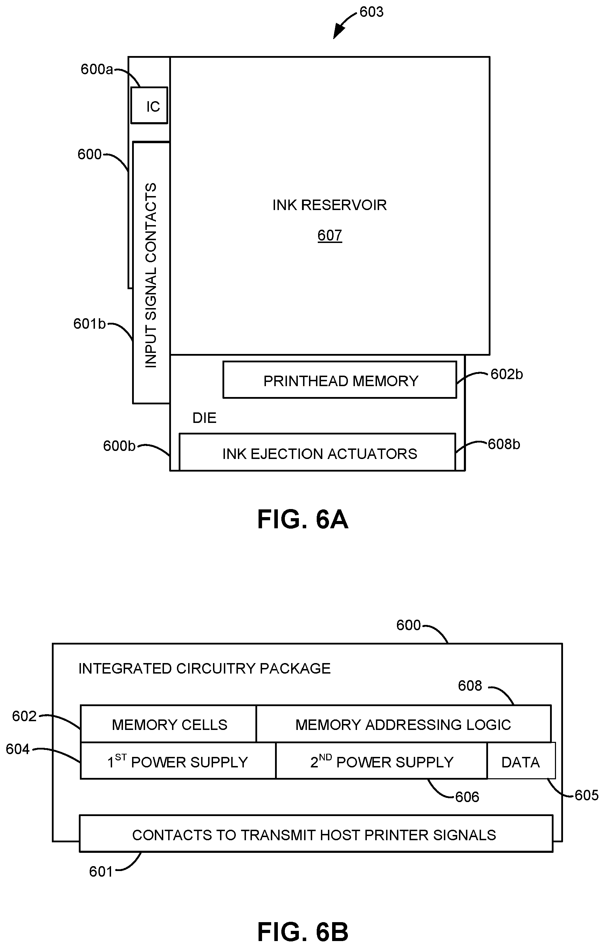

FIG. 6A illustrates an inkjet printhead cartridge 603 including an ink ejection die 600b and a package 600 including an integrated circuit 600a, where the integrated circuit 600a may represent any of the example integrated circuits disclosed herein. The package 600 and/or integrated circuit 600a may include a flat substrate such as a flexible circuit (sometimes referred to as a tab head assembly, flexible circuit assembly, or flexible printed circuit board) or a printed circuit board, to facilitate attachment to the cartridge 603 without inhibiting connection of the cartridge 603 to the printer receiving station. The die 600b includes ink ejection actuators 608b. The combination of the integrated circuit 600a and package 600 may be referred to as integrated circuitry package 600.

FIG. 6B illustrates a diagram of the package 600 of FIG. 6A. Contacts 601b including the first and second power supply nodes 604, 606 and memory read/write (e.g., data) contacts 605 are configured to align to corresponding original signal contacts 601b of the print cartridge 603 to supply power to, read, and write to the plurality of off-die memory cells 602 of the package 600. The integrated circuit 600a and its contacts 601 are configured to divert signals, originally intended for other on-die memory cells 602b residing on a fluid ejection die of the print cartridge 603, to the plurality of off-die memory cells 602. The package contact array 601 is configured to directly and/or indirectly connect to host printer contacts. The package 600 is arranged so that, when the package is attached to the cartridge 603, the contacts 601 are aligned to the cartridge contacts 601b, so that the first and/or second power supply signals are both rerouted to the integrated circuit 600a and transmitted to the ink ejection die 600b, while at least some of the memory read/write data signals over data contact 605 can be intercepted without further transmission to the die 600b. Other read/write signals may be transmitted to the die 600b depending on detecting whether or not the memory read/write function is enabled, for example using memory addressing logic 608. Memory addressing logic 608 may be used to address individual memory cells 602.

In one example, the cartridge 603 is a used, refurbished, and/or refilled print cartridge comprising an ink reservoir 607. In one example, the die 600b is a used die while the reservoir 607 is not previously used. In both embodiments we can refer to a refurbished cartridge 603 because the die 600b has been refurbished. A refurbished print cartridge 603 may include at least a previously used fluid ejection die 600b including a plurality of fluid actuation devices 608b and a plurality of at least partially written and/or at least partially disabled memory cells 602b; an ink reservoir 607; a printer signal contact array 601b connected to the fluid ejection die 600b; and/or the integrated circuitry package 600, attached to a wall of the print cartridge 603. The plurality of off-die memory cells 602 are to be connected to the host printer contacts for memory reading and writing, using the package contacts 601. A first power supply node 604 of the package 600 is connected to at least one of these contacts 601 (i.e., to a single contact or multiple contacts) to supply power to the plurality of memory cells 602 to write data to the plurality of memory cells 602. A second power supply node 606 of the package 600 is connected to at least one of the package contacts 601 (i.e., to a single contact or multiple contacts) to supply power to the plurality of memory cells 602 to read data from the plurality of memory cells. In one example, the package 600 includes voltage regulating circuitry to convert to a customized memory cell reading/writing voltage.

Although specific examples have been illustrated and described herein, a variety of alternate and/or equivalent implementations may be substituted for the specific examples shown and described without departing from the scope of the present disclosure. This application is intended to cover any adaptations or variations of the specific examples discussed herein. Therefore, it is intended that this disclosure be limited only by the claims.

## Claims

1. A print cartridge circuitry component (600) comprising:
an integrated circuit (100a, 100b) for association with a plurality of fluid actuation devices (110, 408, 608b) and comprising input signal contacts (601) to receive input signals from a host printer, the integrated circuit comprising:
a plurality of memory cells (102, 602);
a first power supply node (104, 604) to supply power to the plurality of memory cells to write data to the plurality of memory cells, wherein the first power supply node is to supply a first voltage and a first maximum current;
a second power supply node (106, 606) to supply power to the plurality of memory cells to read data from the plurality of memory cells, wherein the second power supply node is to supply a second voltage and a second maximum current and wherein the first voltage is greater than the second voltage, and the first maximum current is greater than the second maximum current;
a memory cell power node (210) electrically coupled to the plurality of memory cells;
a first voltage regulator (202) to generate a memory-write voltage on the memory cell power node based on the first voltage to write data to the plurality of memory cells; and
a second voltage regulator (206) to generate a memory-read voltage on the memory cell power node based on the second voltage to read data from the plurality of memory cells,
wherein the memory-write voltage is greater than the memory-read voltage.

2. The print cartridge circuitry component of claim 1, wherein the second power supply node is to supply less than 7V and the first power supply node is to supply more than 9V.

3. The print cartridge circuitry component of claim 1 or 2, wherein the plurality of memory cells are readable with the first power supply node disabled.

4. The print cartridge circuitry component of any of claims 1-3, the integrated circuit further comprising:
a plurality of fluid actuation devices,
wherein the first power supply node is to supply power to the plurality of fluid actuation devices.

5. The print cartridge circuitry component of any of claims 1-4, the integrated circuit further comprising:
a logic circuit,
wherein the second power supply node is to supply power to the logic circuit
optionally wherein the logic circuit is to control reading and writing of data to the plurality of memory cells and firing of the plurality of fluid actuation devices.

6. The print cartridge circuitry component of claim 1, the integrated circuit further comprising:
a voltage isolation component between the first voltage regulator and the memory cell power node.

7. A print cartridge comprising an ink reservoir and an ink ejection die comprising the print cartridge circuitry component of any of claims 1-6.

8. The print cartridge circuitry component of any of claims 1-6 comprising:
an off-die package comprising:
the integrated circuit wherein the memory cells are off-die; and
contacts connected to the first and second power supply nodes and
a memory read/write data contact to transmit corresponding printer signals when installed, to supply power to, read, and write to the plurality of off-die memory cells wherein signals originally intended for on-die memory cells residing on a fluid ejection die of the print cartridge are diverted to the plurality of off-die memory cells.

9. A used, refurbished, and/or refilled print cartridge comprising the print cartridge circuitry component of claim 8 connected to printer signal input contacts of the print cartridge.

10. A print cartridge fluid ejection die (100b, 400, 600b) comprising:
a first power supply node (104) to supply a first voltage; a second power supply node (106) to supply a second voltage a plurality of fluid actuation devices (110, 408, 608b) to receive power from the first power supply node;
a plurality of memory cells (102) to receive power from the first power supply node during write operations and from the second power supply node during read operations;
a logic circuit (108) to receive power from the second power supply node wherein the first voltage is greater than the second voltage;
a first voltage regulator (202) to generate a memory-write voltage based on the first voltage to write data to the plurality of memory cells;
**characterised in that** the print cartridge fluid ejection die further comprising:
a second voltage regulator (206) to generate a memory-read voltage based on the second voltage to read data from the plurality of memory cells,
wherein the memory-write voltage is less than the first voltage, and the memory-read voltage is less than or equal to the second voltage.

11. The print cartridge fluid ejection die of claim 10, wherein:
the plurality of memory cells comprise non-volatile memory cells

12. The print cartridge fluid ejection die of any of claims 10 or 11, wherein the first voltage is at least three times the second voltage.

13. A method for accessing a plurality of memory cells (102, 602) of an integrated circuit (100a, 100b) of a print cartridge (603), the method comprising:
powering, via a first power supply (104, 604), the plurality of memory cells of the integrated circuit for write operations;
powering, via a second power supply (106, 606), the plurality of memory cells for read operations,
wherein the first power supply provides a first voltage greater than a second voltage provided by the second power supply;
generating a memory-write voltage based on the first voltage for writing data to the plurality of memory cells;
**characterised by**
generating a memory-read voltage based on the second voltage for reading data from the plurality of memory cells,
wherein the memory-write voltage is greater than the memory-read voltage.

14. The method of claim 13, further comprising:
reading the plurality of memory cells upon the integrated circuit exiting a reset state

15. The method of any of claims 13 or 14, further comprising:
powering, via the first power supply, a plurality of fluid actuation devices of the integrated circuit; and
powering, via the second power supply, a logic circuit of the integrated circuit.

## Patentansprüche

1. Druckpatronen-Schaltlogikkomponente (600), umfassend:
eine integriertes Schaltmodul (100a, 100b) zur Zuordnung zu einer Vielzahl von Fluidbetätigungsvorrichtungen (110, 408, 608b) und umfassend Eingangssignalkontakte (601) zum Empfangen von Eingangssignalen von einem Host-Drucker, wobei das integrierte Schaltmodul umfasst:
eine Vielzahl von Speicherzellen (102, 602);
einen ersten Stromversorgungsknoten (104, 604) zum Versorgen der Vielzahl von Speicherzellen mit Strom, um Daten in die Vielzahl von Speicherzellen zu schreiben, wobei der erste Stromversorgungsknoten dazu dient, eine erste Spannung und einen ersten maximalen Strom zu liefern;
einen zweiten Stromversorgungsknoten (106, 606) zum Versorgen der Vielzahl von Speicherzellen mit Strom, um Daten aus der Vielzahl von Speicherzellen zu lesen, wobei der zweite Stromversorgungsknoten dazu dient, eine zweite Spannung und einen zweiten maximalen Strom zu liefern und wobei die erste Spannung größer als die zweite Spannung ist und der erste maximale Strom größer als der zweite maximale Strom ist;
einen Speicherzellen-Stromknoten (210), der elektrisch an die Vielzahl von Speicherzellen gekoppelt ist; einen ersten Spannungsregler (202) zum Erzeugen einer Speicherschreibspannung an dem Speicherzellen-Stromknoten basierend auf der ersten Spannung zum Schreiben von Daten in die Vielzahl von Speicherzellen; und
einen zweiten Spannungsregler (206) zum Erzeugen einer Speicherlesespannung an dem Speicherzellen-Stromknoten basierend auf der zweiten Spannung zum Lesen von Daten aus der Vielzahl von Speicherzellen,
wobei die Speicherschreibspannung größer ist als die Speicherlesespannung.

2. Druckpatronen-Schaltlogikkomponente nach Anspruch 1, wobei der zweite Stromversorgungsknoten dazu dient, weniger als 7 V zu liefern und der erste Stromversorgungsknoten dazu dient, mehr als 9 V zu liefern.

3. Druckpatronen-Schaltlogikkomponente nach Anspruch 1 oder 2, wobei die Vielzahl von Speicherzellen lesbar sind, wenn der erste Stromversorgungsknoten deaktiviert ist.

4. Druckpatronen-Schaltlogikkomponente nach einem der Ansprüche 1-3, wobei das integrierte Schaltmodul ferner umfasst:
eine Vielzahl von Fluidbetätigungsvorrichtungen;
wobei der erste Stromversorgungsknoten dazu dient, Strom an die Vielzahl von Fluidbetätigungsvorrichtungen zu liefern.

5. Druckpatronen-Schaltlogikkomponente nach einem der Ansprüche 1-4, wobei das integrierte Schaltmodul ferner umfasst:
einen logischen Schaltkreis,
wobei der zweite Stromversorgungsknoten dazu ausgelegt ist, den logischen Schaltkreis optional mit Strom zu versorgen,
wobei der logische Schaltkreis dazu dient, das Lesen und Schreiben von Daten zu der Vielzahl von Speicherzellen und das Auslösen der Vielzahl von Fluidbetätigungsvorrichtungen zu steuern.

6. Druckpatronen-Schaltlogikkomponente nach Anspruch 1, wobei das integrierte Schaltmodul ferner umfasst:
eine Spannungstrennungskomponente zwischen dem ersten Spannungsregler und dem Speicherzellen-Stromknoten.

7. Druckpatrone, umfassend ein Tintenreservoir und eine Tintenausstoßdüse, umfassend die Druckpatronen-Schaltlogikkomponente nach einem der Ansprüche 1-6.

8. Druckpatronen-Schaltlogikkomponente nach einem der Ansprüche 1-6, umfassend:
ein Matrizengehäuse, umfassend:
das integrierte Schaltmodul, wobei die Speicherzellen abseits der Matrize sind; und Kontakte, die mit dem ersten und zweiten Stromversorgungsknoten verbunden sind, und
einen Speicherlese-/schreibdatenkontakt zum Übertragen entsprechender Druckersignale, wenn installiert, zum Versorgen mit Strom, Auslesen und Beschreiben der Vielzahl von matrizenfernen Speicherzellen, wobei Signale, die ursprünglich für Matrizenspeicherzellen bestimmt sind, die sich auf einer Druckpatronenfluid-Ausstoßdüse befinden, zu der Vielzahl von matrizenfernen Speicherzellen umgeleitet werden.

9. Gebrauchte, wiederaufbereitete und/oder wiederbefüllte Druckpatrone, umfassend die Druckpatronen-Schaltlogikkomponente nach Anspruch 8, die mit Druckersignaleingangskontakten der Druckpatrone verbunden ist.

10. Eine Druckpatronenfluid-Ausstoßdüse (100b, 400, 600b), umfassend:
einen ersten Stromversorgungsknoten (104) zum Zuführen einer ersten Spannung:
einen zweiten Stromversorgungsknoten (106) zum Zuführen einer zweiten Spannung:
eine Vielzahl von Fluidbetätigungsvorrichtungen (110, 408, 608b), um Leistung von dem ersten Stromversorgungsknoten zu empfangen;
eine Vielzahl von Speicherzellen (102), um während Schreibvorgängen Strom von dem ersten Stromversorgungsknoten und während Lesevorgängen Strom von dem zweiten Stromversorgungsknoten zu empfangen;
einen logischen Schaltkreis (108) zum Empfangen von Strom von dem zweiten Stromversorgungsknoten,
wobei die erste Spannung größer ist als die zweite Spannung;
einen ersten Spannungsregler (202) zum Erzeugen einer Speicherschreibspannung basierend auf der ersten Spannung zum Schreiben von Daten in die Vielzahl von Speicherzellen;
**dadurch gekennzeichnet, dass** die Druckpatronenfluid-Ausstoßdüse ferner umfasst:
einen zweiten Spannungsregler (206) zum Erzeugen einer Speicherlesespannung basierend auf der zweiten Spannung zum Lesen von Daten aus der Vielzahl von Speicherzellen,
wobei die Speicherschreibspannung geringer ist als die erste Spannung und die Speicherlesespannung geringer oder gleich der zweiten Spannung ist.

11. Druckpatronenfluid-Ausstoßdüse nach Anspruch 10, wobei:
die Vielzahl von Speicherzellen nichtflüchtige Speicherzellen umfasst.

12. Druckpatronenfluid-Ausstoßdüse nach einem der Ansprüche 10 oder 11, wobei die erste Spannung mindestens dreimal so hoch ist wie die zweite Spannung.

13. Verfahren zum Zugreifen auf eine Vielzahl von Speicherzellen (102, 602) eines integrierten Schaltmoduls (100a, 100b) einer Druckpatrone (603), wobei das Verfahren umfasst:
Versorgen, über eine erste Stromversorgung (104, 604), der Vielzahl von Speicherzellen des integrierten Schaltmoduls für Schreibvorgänge;
Versorgen, über eine zweite Stromversorgung (106, 606), der Vielzahl von Speicherzellen für Lesevorgänge,
wobei die erste Stromversorgung eine erste Spannung bereitstellt, die größer ist als eine zweite Spannung, die von der zweiten Stromversorgung bereitgestellt wird;
Erzeugen einer Speicherschreibspannung basierend auf der ersten Spannung zum Schreiben von Daten in die Vielzahl von Speicherzellen;
**gekennzeichnet durch**
Erzeugen einer Speicherlesespannung basierend auf der zweiten Spannung zum Lesen von Daten aus der Vielzahl von Speicherzellen,
wobei die Speicherschreibspannung größer ist als die Speicherlesespannung.

14. Verfahren nach Anspruch 13, ferner umfassend:
Lesen der Vielzahl von Speicherzellen auf dem integrierten Schaltmodul nach Beendigung eines Rücksetzzustands.

15. Verfahren nach einem der Ansprüche 13 oder 14, ferner umfassend:
Versorgen, über die erste Stromversorgung, einer Vielzahl von Fluidbetätigungsvorrichtungen des integrierten Schaltmoduls; und
Versorgen, über die zweite Stromversorgung, eines logischen Schaltkreises des integrierten Schaltmoduls.

## Revendications

1. Composant de circuiterie de cartouche d'impression (600) comprenant :
un circuit intégré (100a, 100b) destiné à être associé à une pluralité de dispositifs d'actionnement de fluide (110, 408, 608b) et comprenant des contacts de signal d'entrée (601) pour recevoir des signaux d'entrée provenant d'une imprimante hôte, le circuit intégré comprenant :
une pluralité de cellules de mémoire (102, 602) ;
un premier nœud d'alimentation électrique (104, 604) pour alimenter en électricité la pluralité de cellules de mémoire afin d'écrire des données dans la pluralité de cellules de mémoire, dans lequel le premier nœud d'alimentation électrique est destiné à fournir une première tension et un premier courant maximal ;
un second nœud d'alimentation électrique (106, 606) pour alimenter en électricité la pluralité de cellules de mémoire afin de lire des données provenant de la pluralité de cellules de mémoire, dans lequel le second nœud d'alimentation électrique est destiné à fournir une seconde tension et un second courant maximal et dans lequel la première tension est supérieure à la seconde tension, et le premier courant maximal est supérieur au second courant maximal ;
un nœud d'alimentation de cellule de mémoire (210) couplé électriquement à la pluralité de cellules de mémoire ;
un premier régulateur de tension (202) pour générer une tension d'écriture de mémoire sur le nœud d'alimentation de cellule de mémoire sur la base de la première tension pour écrire des données dans la pluralité de cellules de mémoire ; et
un second régulateur de tension (206) pour générer une tension de lecture de mémoire sur le nœud d'alimentation de cellule de mémoire sur la base de la seconde tension pour lire des données à partir de la pluralité de cellules de mémoire,
dans lequel la tension d'écriture de mémoire est supérieure à la tension de lecture de mémoire.

2. Composant de circuiterie de cartouche d'impression selon la revendication 1, dans lequel le second nœud d'alimentation est destiné à fournir moins de 7 V et le premier nœud d'alimentation est destiné à fournir plus de 9 V.

3. Composant de circuiterie de cartouche d'impression selon la revendication 1 ou 2, dans lequel la pluralité de cellules de mémoire sont lisibles avec le premier nœud d'alimentation désactivé.

4. Composant de circuiterie de cartouche d'impression selon l'une quelconque des revendications 1 à 3, le circuit intégré comprenant en outre :
une pluralité de dispositifs d'actionnement de fluide,
dans lequel le premier nœud d'alimentation électrique est destiné à alimenter en électricité la pluralité de dispositifs d'actionnement de fluide.

5. Composant de circuiterie de cartouche d'impression selon l'une quelconque des revendications 1 à 4, le circuit intégré comprenant en outre :
un circuit logique,
dans lequel le second nœud d'alimentation électrique est destiné à alimenter en électricité le circuit logique
éventuellement dans lequel le circuit logique est destiné à commander la lecture et l'écriture de données dans la pluralité de cellules de mémoire et le déclenchement de la pluralité de dispositifs d'actionnement de fluide.

6. Composant de circuiterie de cartouche d'impression selon la revendication 1, le circuit intégré comprenant en outre :
un composant d'isolation de tension entre le premier régulateur de tension et le nœud d'alimentation de cellule de mémoire.

7. Cartouche d'impression comprenant un réservoir d'encre et une matrice d'éjection d'encre comprenant le composant de circuiterie de cartouche d'impression selon l'une quelconque des revendications 1 à 6.

8. Composant de circuiterie de cartouche d'impression selon l'une quelconque des revendications 1 à 6, comprenant :
un boîtier hors matrice comprenant :
le circuit intégré dans lequel les cellules de mémoire sont hors-matrice ; et des contacts connectés aux premier et second nœuds d'alimentation électrique et
un contact de données de lecture/écriture de mémoire pour transmettre des signaux d'imprimante correspondants lorsqu'il est installé, afin d'alimenter en électricité, de lire et d'écrire dans la pluralité de cellules de mémoire hors matrice, dans lequel les signaux initialement destinés aux cellules de mémoire sur matrice résidant sur une matrice d'éjection de fluide de la cartouche d'impression sont détournés vers la pluralité de cellules de mémoire hors matrice.

9. Cartouche d'impression d'occasion, remise à neuf et/ou rechargée comprenant le composant de circuiterie de cartouche d'impression selon la revendication 8 connecté à des contacts d'entrée de signal d'imprimante de la cartouche d'impression.

10. Matrice d'éjection de fluide de cartouche d'impression (100b, 400, 600b) comprenant :
un premier nœud d'alimentation électrique (104) pour fournir une première tension :
un second nœud d'alimentation électrique (106) pour fournir une seconde tension :
une pluralité de dispositifs d'actionnement de fluide (110, 408, 608b) pour recevoir de l'énergie provenant du premier nœud d'alimentation électrique ;
une pluralité de cellules de mémoire (102) pour recevoir de l'énergie provenant du premier nœud d'alimentation électrique pendant des opérations d'écriture et provenant du second nœud d'alimentation électrique pendant des opérations de lecture ;
un circuit logique (108) pour recevoir de l'énergie provenant du second nœud d'alimentation électrique,
dans laquelle la première distance est inférieure à la seconde distance ;
un premier régulateur de tension (202) pour générer une tension d'écriture de mémoire sur la base de la première tension pour écrire des données dans la pluralité de cellules de mémoire ;
**caractérisée en ce que** la matrice d'éjection de fluide de cartouche d'impression comprend en outre :
un second régulateur de tension (206) pour générer une tension de lecture de mémoire sur la base de la seconde tension pour lire des données provenant de la pluralité de cellules de mémoire,
dans laquelle la tension d'écriture de mémoire est inférieure à la première tension, et la tension de lecture de mémoire est inférieure ou égale à la seconde tension.

11. Matrice d'éjection de fluide de cartouche d'impression selon la revendication 10, dans laquelle :
la pluralité de cellules de mémoire comprend des cellules de mémoire non volatiles

12. Matrice d'éjection de fluide de cartouche d'impression selon l'une quelconque des revendications 10 ou 11, dans laquelle la première tension est au moins trois fois supérieure à la seconde tension.

13. Procédé permettant d'accéder à une pluralité de cellules de mémoire (102, 602) d'un circuit intégré (100a, 100b) d'une cartouche d'impression (603), le procédé comprenant :
l'alimentation, par l'intermédiaire d'une première alimentation électrique (104, 604), de la pluralité de cellules de mémoire du circuit intégré pour des opérations d'écriture ;
l'alimentation, par l'intermédiaire d'une seconde alimentation électrique (106, 606), de la pluralité de cellules de mémoire pour des opérations de lecture,
dans lequel la première alimentation électrique fournit une première tension supérieure à une seconde tension fournie par la seconde alimentation électrique ;
la génération d'une tension d'écriture de mémoire sur la base de la première tension d'écriture de données dans la pluralité de cellules de mémoire ;
**caractérisé par**
la génération d'une tension de lecture de mémoire sur la base de la seconde tension pour la lecture de données provenant de la pluralité de cellules de mémoire,
dans lequel la tension d'écriture de mémoire est supérieure à la tension de lecture de mémoire.

14. Procédé selon la revendication 13, comprenant en outre :
la lecture de la pluralité de cellules de mémoire lorsque le circuit intégré sort d'un état de réinitialisation

15. Procédé selon l'une quelconque des revendications 13 à 14, comprenant en outre :
l'alimentation, par l'intermédiaire de la première alimentation électrique, d'une pluralité de dispositifs d'actionnement de fluide du circuit intégré ; et
l'alimentation, par l'intermédiaire de la seconde alimentation électrique, d'un circuit logique du circuit intégré.
